# EUROPEAN PATENT SPECIFICATION

(11) **EP 3 104 184 B1**
(45) Date of publication and mention of the grant of the patent: **02.11.2022**
(21) Application number: 14881049.2
(22) Date of filing: 12.03.2014
(51) Int. Cl.: G01R 31/08, B64D 27/08, B64D 47/00, H02G 1/02

(54) **METHOD AND APPARATUS FOR LOCATING FAULTS IN OVERHEAD POWER TRANSMISSION LINES**
VERFAHREN UND VORRICHTUNG ZUR LOKALISIERUNG VON FEHLERN BEI FREILEITUNGEN
PROCÉDÉ ET DISPOSITIF DE DIAGNOSTIC DE LIGNES ÉLECTRIQUES AÉRIENNES

(30) Priority: 03.02.2014 RU 2014103626
(43) Date of publication of application: 14.12.2016
(73) Proprietor: OBSCHESTVO S OGRANICHENNOJ OTVETSTVENNOSTYU "LABORATORIYA BUDUSCHEGO", g. Ekaterinburg 620109 (RU)
(72) Inventor: VINOGRADOVA, Lubov Olegovna, g. Ekaterinburg 620027 (RU); KRIVOROTOV, Vadim Aleksandrovich, g. Zarechny 624250 (RU); LEMEKH, Alexander Viktorovich, g. Ekaterinburg 620109 (RU); TRETYAKOV, Viacheslav Andreyevich, Stuttgart 70190 (DE); SHASTIN, Arnold Georgiyevich, g. Zarechny 624250 (RU)
(74) Representative: Winter, Brandl - Partnerschaft mbB
(86) International application number: PCT/RU2014/000160
(87) International publication number: WO 2015/115927

(56) References cited:
- CN-A- 1 645 284
- CN-A- 101 807 080
- CN-A- 102 340 113
- CN-A- 102 780 177
- CN-A- 102 941 920
- CN-A- 103 235 602
- CN-U- 202 071 987
- US-A- 4 818 990
- US-A- 4 904 996
- US-A1- 2006 114 122
- US-A1- 2006 114 122
- US-A1- 2011 196 535

## Description

The claimed group of inventions relates to power engineering and can be used for locating faults in overhead power transmission lines.

The prior art knows a method of locating faults in high-voltage power transmission lines, which consists of recording high-frequency electrical pulses near the power transmission line with the aid of an electromagnetic sensor and a digital oscillograph connected to it by parallel overflight of the line. The measuring apparatus is moved along the power transmission line with the aid of an automatically controllable compact pilotless aircraft or drone [RU2421746, IPC G01R31/08, 2/10/2010].

The prior art knows a method of aerially locating faults in power transmission lines, which consists of recording high-frequency electrical pulses near the power transmission lines with the aid of an electromagnetic sensor and a digital oscillograph connected to it during parallel overflight of the line. The measuring device is moved along the power transmission line route with the aid of an automatically controllable compact pilotless aircraft or drone. During the flight, the magnetic field intensity is measured with sensors located on the aircraft's wingtips, and the average magnetic field intensity is calculated as *H_{avg}* = (*Hᵣ* + *Hₗ*)/2 and used for automatic maintenance of the aircraft's vertical position relative to the power transmission line conductors [RU2483314, IPC G0IR31/08, 11/18/2011].

As a prototype, a method of locating faults in power transmission lines was chosen, which is effected with the aid of a robot for locating faults in power transmission lines, which includes installing the robot for locating faults in power transmission lines with the capability of movement near and along the power transmission lines along the lightning-protector cable or power conductor; controlling the movement of the apparatus for locating faults in power transmission lines along overhead power transmission lines and across their pylons with the aid of a drive system; controlling the operation of the apparatuses for inspecting overhead power transmission lines; and acquiring, processing, and analyzing data collected thereby [CN102317040, IPC B25J13/08; B60K16/00, 2/10/2011].

The prior art knows an apparatus for finding faults in power transmission lines, which contains a device for radio transmission of a wireless signal to a ground station, a microcontroller, and a video camera whose images from the camera can be transmitted and acquired with the aid of the radio transmitter, one ground station for receiving the wireless signal from the radio transmitter, and a microcomputer [CN201489078, IPC G01N21/88; G01R31/08, 6/15/2009].

The prior art knows a robot for locating faults in overhead power transmission lines, which includes a communication and control system, a drive system, a camera, a set of sensors for recording the condition of the power transmission lines, and a navigation device [CN102317040, IPC B25J13/08; B60K16/00, 2/10/2011].

As a prototype, a self-propelled fault-locating apparatus was chosen, which contains a control system, a set of sensors for recording the condition of the power transmission lines, and a drive system and capture device made to permit the self-propelled fault-locating apparatus to move along the overhead power transmission lines and across their pylons [JP2012257372, IPC H02G1/02, 6/8/2011].

The shortcoming of the prior-art apparatuses and the method chosen as a prototype is the impossibility of locating faults in the absence of special equipment such as a crane needed to place the apparatus for locating faults in overhead power transmission lines on the lightning-protector cable or to overcome anchor pylons, where the direction of the lightning-protector cable varies by some angle.

The technical problem addressed by the claimed method and apparatus is that of expanding the range of resources.

The technical result is that the range of methods and apparatuses for locating faults in overhead power transmission lines is expanded, and the capability of locating faults in overhead power transmission lines is provided without additional special equipment.

The prior art knows a self-propelled, autonomous mechanical apparatus made with the capability of connecting to the supply network of the conductor and moving along it, and capable of recognizing basic states of the conductor and reporting them, where the apparatus contains a drive system, case, central processor, memory devices, sensor electronics, communication interface, and mating element [US7496459, IPC G01R31/08, 4/3/2007].

The most similar in technical essence to the component of the apparatus for locating faults in overhead power transmission lines is a vehicle for use on a power transmission lines, which includes three wheels, two movable pressure (clamping) wheels and a motor, which consist of a drive system, battery, and control system connected to the motor [US6494141, IPC H02G1/02; H02G7/16; B61B7/06; E01B25/16, 2/22/2000].

Document CN 103 235 602 A disclosed an automatic photography control device for a power line inspection unmanned aerial vehicle, and a control method thereof. The automatic photography control device is fixed on metal structure at the front end of an unmanned aerial vehicle body and located above a detection head. The automatic photography control device mainly comprises a control circuit and a battery. The control circuit and the battery are disposed in a box. The control circuit comprises a single-chip microcomputer, a servo steering engine, a wireless receiver, an LCD (liquid crystal display), keys, a camera photography control module, a power management module, and a battery. The single-chip microcomputer is respectively connected with the servo steering engine, the wireless receiver, the LCD, the keys, the camera photography control module, the power management module and the battery. The battery is further connected with the power management module. The automatic photography control device is obtained according to experiments and practical needs in power line inspection with the unmanned aerial vehicle, and allows the unmanned aerial vehicle to take photos efficiently, quickly and simply during power line section Document CN 101 807 080 A disloses a robot airship control system for overhead line inspection and a control method thereof. The control system comprises a on-board system and a ground-based system, wherein the on-board system has a structure that: a master controller DSP is connected with various sensors, a wireless communication module, a motor drive circuit, an image processor DSP and the like through analog-to-digital conversion ports, serial ports and other ports, and the image processor DSP is connected with an infrared CCD through an HPI port; the ground-based system has a structure that: an interface singlechip is connected with a ground PC, wireless communication equipment and a manual remote controller through serial ports, I/O and other ports; the on-board system and the ground-based system are communicated through an on-board wireless communication module and a ground-based wireless communication module; and a wireless camera transmits image information to the ground-based system through wireless video signals, and displays the image information on an image monitor. The robot airship control system for the overhead line inspection has three patterns, namely an infrared vision navigation pattern, a GPS navigation pattern and a manual remote control pattern, and has the advantages of high inspection efficiency, high cruisingability and high safety.

Document CN 102 941 920 A discloses a high-tension transmission line inspection robot based on a multi-rotor aircraft, which comprises a four-rotor aircraft and an inspection system, wherein a double-power module supplies power to the four-rotor aircraft and the inspection system; the four-rotor aircraft comprises a robot body, four rotors, four rotor motors and four rotor motor drivers, the rotors, the rotor motors and the rotor motor drivers are matched, the four rotors are fixedly arranged on respective rotor motors, and the four drivers are respectively connected with respective rotor motors 3; and the inspection system performs shooting and data transmission on high-tension transmission lines. The robot disclosed by the invention performs air flight inspection based on four rotors, and is high in air flight stability and good in inspection speed. Through wireless camera shooting control, a visible light camera can be moved to a position near a suspected fault point so as to realize the emphasized detection of suspected fault points of the high-tension transmission lines.

Document CN 1 645 284 A discloses a robot airplane for tour inspection of power line in counterwise driving structure of coxial double propeller uses two engines to control flight stability, GPS and GIS to confirm flight path, computer processor to adjust flight attitute and battery to provide power for motor, transducer and data link system. Its control system consists of navigation system, autonomous planning system, data link system and on line detection system. Document CN 102 340 113 A discloses a multi-rotor-wing automatic positioning detector used for a transmission line. A patrol nacelle of the detector is fixedly connected with a multi-rotor-wing micro air vehicle by a connection structure; a master control board is fixed on the airframe of the multi-rotor-wing micro air vehicle; a power supply module is fixed on the patrol nacelle; a crawling mechanism is formed by a power device fixed on a side arm of the patrol nacelle and idler wheels connected with the power device; the master control board controls the power supply module to supply power for a driving mechanism of the multi-rotor-wing micro air vehicle or the power device of the crawling mechanism; an infrared video camera and a visible light camera are arranged on the inner wall of the patrol nacelle; the visible light camera is used for shooting the transmission line and the ambient environments and transmitting the information of the shot images to a ground station system by the master control board in real time; and the infrared video camera is used for detecting faults of the transmission line and transmitting the fault information to the ground station system by the master control board in real time. The multi-rotor-wing automatic positioning detector can be used in fields, has the advantages of high working efficiency and good safety, and has a real-time visual patrol function.

Document CN 202 071 987 U discloses an unmanned helicopter for patrolling power transmission lines, which comprises a helicopter main body, a flight control system and a camera shooting system. The flight control system and the camera shooting system are arranged in the helicopter main body, wherein the flight control system comprises a global position system (GPS) device, a six-freedom-degree inertia measurement unit, a magnetic field meter, a barometric altimeter, a navigating appliance sending control orders to the helicopter main body and a wireless receiving and dispatching device exchanging data with an earth station. The camera shooting system comprises a gyro stabilization holder, a camera shooting device arranged on the gyro stabilization holder, a camera shooting controller for controlling working of the camera shooting device and the gyro stabilization holder, a wireless video transmitter sending images to the earth station and a wireless order receiving device for receiving camera shooting orders from the earth station. The unmanned helicopter utilizes an unmanned plane to patrol lines, can improve the quality and the efficiency of patrolling lines, can reduce operation risks and labor intensity of maintaining workers, Improves working environments of power line patrols, and enhances professional level for maintaining and managing the running of the power transmission lines.

Document CN 102 780 177 A discloses an overhead power line inspection data collection method based on a flying robot and belongs to the field of power line inspection data collection. The method includes that the multi-rotor flying robot is used as a collection tool for collecting data of power transmission lines and towers and can realize switching between autonomous flying and manual remote control, and the manual remote control is adopted for layered detection, especially in tower inspection. Data of static Images and video Images are respectively stored in the flying robot and a ground base station, and hierarchical indexed storage is adopted to store the data for the convenience of retrieval Inquiry.; The overhead power line inspection data collection method based on the flying robot has the advantages that problems of low efficiency and Inconvenience in data recording and retrieving of manual inspection, high safety risk and strict personnel requirement of manned helicopter inspection and the like are solved, the inspection collection process is flexible, the body is high in stability, and inspection effect is good especially for towers with complex wire arrangement.

Document : US 2006/114122 A1 discloses a power line inspection apparatus comprising a vehicle body to which is mounted a power line traversal means, a power line inspection means to draw power from a power line to which it is attached, in use.

The next-coming prior art document CN 102 340 A relates to an automatic positioning detector with many rotors that is applicable to polling a transmission line. A straight line displacement mechanism can be moved in relation to a roller for clamping a power transmission line.

The shortcoming of the prior-art apparatuses is the difficulty of initially installing the apparatuses for locating faults in overhead power transmission lines on the lightning-protector cable or power conductor due to the absence of components that would set the trajectory of the lightning-protector cable or power conductor, respectively, within the fault-locating apparatus,

The technical problem addressed by a component of the claimed apparatus is that of expanding the range of apparatuses and simplifying the process of installing the apparatus for locating faults in overhead power transmission lines on the lightning-protector cable or power conductor.

This object is solved by the subject matter of claim 1. Further aspects are disclosed in the subclaim.

The technical result is that the range of apparatuses for locating faults in overhead power transmission lines is expanded, and the process of installing the apparatus for locating faults in overhead power transmission lines on the lightning-protector cable or power conductor is simplified by the use of guides attached to its case and made with the capability of setting the trajectory of the lightning-protector cable or power conductor within the apparatus for locating faults in overhead power transmission lines to a position permitting its installation on the lightning-protector cable or power conductor.

The apparatus for locating faults in overhead power transmission lines is defined by the appended claim 1.

The drive system consists of two traveling rollers and a clamping roller made with the capability of movement relative to the lightning-protector cable in the vertical plane with the aid of an additional electric drive and clamping of the lightning-protector cable to the traveling rollers. The guides are made with the capability of setting the trajectory of the lightning-protector cable or power conductor within the apparatus for locating faults in overhead power transmission lines to a position permitting the apparatus for locating faults in overhead power transmission lines to be installed on the lightning-protector cable or power conductor.

The helicopter-type aircraft consists of at least a two-rotor helicopter with an electronic stabilizer, a control system, and an electronic device for determining coordinates. The helicopter-type aircraft can be made in the form of a pilotless aircraft or remotely piloted vehicle. The helicopter-type aircraft is attached to outside of the case of the apparatus for locating faults in overhead power transmission lines.

The battery can be attached to the outside of the case of the apparatus for locating faults in overhead power transmission lines.

The apparatuses for inspecting overhead power transmission lines are designed to find faults in the condition and spatial position of the following elements: lightning-protector cable, power conductor, pylon structural elements, suspension clamp and anchor of the lightning-protector cable, insulator fasteners, insulator strings, vibration dampers, and other equipment. The following may be used as apparatuses for locating faults in overhead power transmission lines: a high-resolution video camera with the capability of varying focus over wide ranges, a television for finding faults in the condition of power conductors, a laser scanner for mapping the route and crossings, an ultrasound scanner for the lightning-protector cable, an ultraviolet scanner for diagnosing discharges and coronas, and other devices with the same uses. The apparatuses for inspecting overhead power transmission lines are attached on the outside of the apparatus for locating faults in overhead power transmission lines and may be attached to the case of the apparatus or its external components, for example, on a helicopter-type aircraft.

The apparatus for locating faults in overhead power transmission lines may be realized with the aid of an apparatus that is elucidated by the following drawings. The claimed component is part of the apparatus for locating faults in overhead power transmission lines.

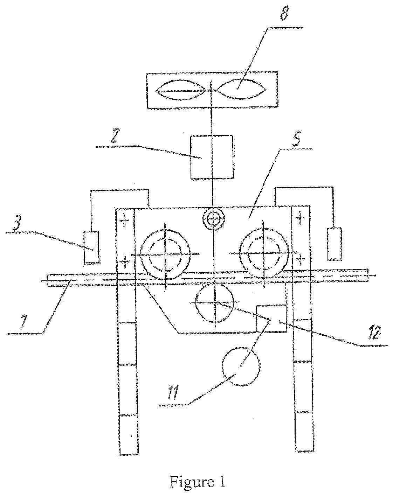

Figure 1: Projection of the apparatus for locating faults in overhead power transmission lines (front view).

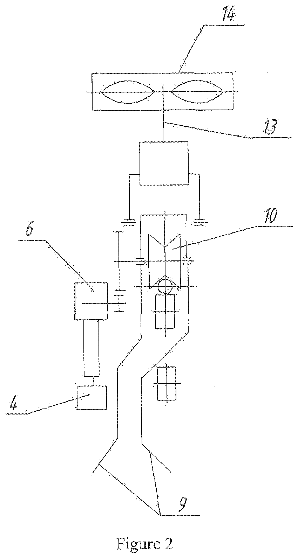

Figure 2: Projection of the apparatus for locating faults in overhead power transmission lines (view from the left).
Figure 3: Set of positions of the apparatus for locating faults in overhead power transmission lines relative to the lightning-protector cable.

The apparatus for locating faults in overhead power transmission lines *1* contains a control system (not designated in the figures), apparatuses for inspecting overhead power transmission lines *2* and *3*, connected to battery *4*, a drive system (not designated in the figures) located in case *5* and connected to motor *6*, made with the capability of locking the position of fault-locating apparatus *1* relative to lightning-protector cable *7* and moving it along and near power transmission lines (not designated in the figure). The apparatus for locating faults in overhead power transmission lines *1* additionally contains helicopter-type aircraft *8*, connected to battery *4*, including a control system (not shown in the figure) and attached to the outside of case *5*, where case *5* is additionally outfitted with guides *9*, made with the capability of setting the trajectory of lightning-protector cable *7* within the apparatus for locating faults in overhead power transmission lines *1* to a position permitting locking of the apparatus for locating faults in overhead power transmission lines *1* relative to lightning-protector cable *7*.

The component (not designated in the figures) of the apparatus for locating faults in overhead power transmission lines contains a control system (not designated in the figures), apparatuses for inspecting overhead power transmission lines *2* and *3*, connected to battery *4*, a drive system (not designated in the figure) located in case *5* and connected to motor *6*, made with the capability of locking the position of fault-finding apparatus *1* relative to lightning-protector cable *7* and moving it along and near the overhead power transmission lines (not designated in the figure). Case *5* is additionally outfitted with guides *9*, made with the capability of setting the trajectory of lightning-protector cable *7* within the apparatus for locating faults in overhead power transmission lines *1* to a position permitting locking of the apparatus for locating faults in overhead power transmission lines *1* relative to lightning-protector cable *7*.

The control system (not designated in the figures) is realized by means of radio control with the aid of an operator control panel and contains a signal receiver (not designated in the figures), a direct-current motor driver (not designated in the figures), and a controller (not designated in the figures).

The drive system (not designated in the figures) consists of two traveling rollers *10* and a clamping roller *11* made with the capability of movement relative to the lightning-protector cable *7* in the vertical plane with the aid of an additional electric drive *12* and clamping of the lightning-protector cable *7* to the traveling rollers *10*.

Guides *9* have a fork-type attachment and consist of curved guides. Guides *9* are attached to the outside of case *5*.

Case *5* contains metal rod *13*, behind which helicopter-type aircraft *8* is attached to it. Helicopter-type aircraft *8* consists of an eight-rotor helicopter with protective enclosure *14*, electronic stabilizer (not designated in the figures), a control system (not designated in the figures) and an electronic device for determining coordinates (not designated in the figures).

Battery *4* is attached to the outside of case *5*.

The following are used as apparatuses for inspecting overhead power transmission lines *2* and *3*: high-resolution video camera *2* with the capability of varying focus over wide ranges, and additional inspection devices *3*: a television for finding faults in the condition of power conductors, a laser scanner for mapping the route and crossings, an ultrasound scanner for the lightning-protector cable, and an ultraviolet scanner for diagnosing discharges and coronas. Each of the apparatuses for inspecting overhead power transmission lines *2* and *3* are attached to the outside of case *5* of the apparatus for locating faults in overhead power transmission lines *1*.

The method of finding faults in overhead power transmission lines includes installing the apparatus for locating faults in overhead power transmission lines *1* on lightning-protector cable *7* with the capability of movement near and along the overhead power transmission lines (not designated in the figures); controlling the movement of the apparatus for locating faults in overhead power transmission lines *1* along the overhead power transmission lines (not designated in the figures) and across their pylons *15* with the aid of a drive system (not designated in the figures); controlling the operation of the apparatuses for inspecting overhead power transmission lines *2* and *3*; and acquiring, processing, and analyzing data collected thereby. The placement of the apparatus for inspecting overhead power transmission lines *1* and controlling its movement across pylons *15* of the overhead power transmission lines is effected with the aid of helicopter-type aircraft *8*, while control of the movement of the apparatus for inspecting overhead power transmission lines *1* across the overhead power transmission line pylons *15* involves removal of apparatus *1* from the lightning-protector cable *7*, overflight of apparatus *1*, and reinstallation on lightning-protector cable *7*.

The operating principle of the claimed inventions is realized as follows.

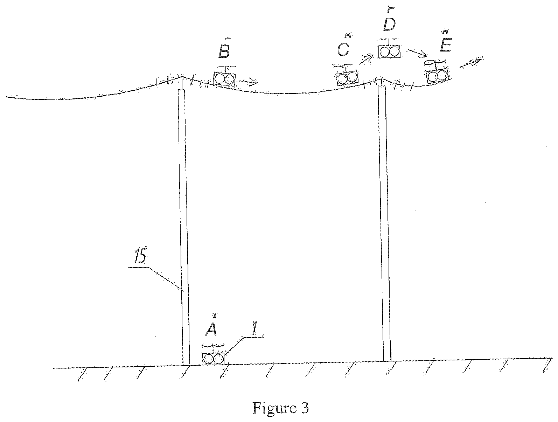

First, the apparatus for finding faults in overhead power transmission lines *1* is installed with the aid of pilotless helicopter-type aircraft *8* from position *A* (Figure 3) to position *B* (Figure 3): helicopter-type aircraft *8* is powered from battery *4* and with the aid of lift and propulsive forces lifts the component of the apparatus for finding faults in overhead power transmission lines (not designated in the figures) to lightning-protector cable *7*, after which the component is installed on lightning-protector cable *7*. Lightning-protector cable *7*, falling between guides *9* and with their aid bypassing clamping roller *11*, falls between clamping roller *11* and traveling rollers *10.* Then clamping roller *11* is lifted by means of additional drive *12* and locks lightning-protector cable 7, ensuring its correct positioning. The movement of pilotless helicopter-type aircraft *8* is controlled with the aid of a control system (not designated in the figures), which receives operator commands sent with the aid of a control panel (not designated in the figures).

Then with the aid of the control system (not designated in the figures), the operator controls the operation of the apparatuses for inspecting overhead power transmission lines 2 and 3, obtains the results of their operation with the aid of the control panel (not designated in the figures), processes and analyzes the incoming data, and controls the movement of the apparatus for finding faults in overhead power transmission lines *1* along lightning-protector cable *7*. Motor *6*, powered by battery *4*, rotates traveling rollers *10*, which moves the apparatus for finding faults in overhead power transmission lines *1*. When the apparatus approaches overhead power transmission line pylon *15*, position *C* (Figure 3) , the operator issues the removal command. Battery *4* delivers power to helicopter-type aircraft *8*, which switches on. Clamping roller *11* is lowered by additional electric drive *12*, releasing lightning-protector cable *7*. Then, controlling the operation of helicopter-type aircraft *8*, the operator releases lightning-protector cable *7* from guides *9* and moves the component of the apparatus across pylon *15*, positions *D* and *E* (Figure 3). Then the apparatus for finding faults in overhead power transmission lines *1* is reinstalled. This set of operations is repeated throughout the operation of apparatus *1*, then fault-finding apparatus *1* is removed from lightning-protector cable *7* and with the aid of pilotless helicopter-type aircraft *8* is lowered to a landing pad (not designated in the figures) or any other level surface of suitable size.

## Claims

1. Apparatus (1) for finding faults in overhead power transmission lines, containing;
a helicopter-type aircraft (8), a control system and an apparatus (2, 3) for inspecting overhead power transmission lines, all connected to a battery (4) which is attached to the outside of a case (5) of the apparatus (1) for finding faults, wherein the apparatus (2, 3) for inspecting overhead transmission lines is attached to the outside of the case (5), wherein the control system is configured to acquire, process and analyse data collected by controlling the operation of the apparatus (2, 3) for inspecting overhead transmission lines,
wherein the apparatus (1) for finding faults further contains a drive system located in the case (5) and connected to a motor (6), which is powered by the battery (4) and which is attached to the battery (4), the drive system is configured to lock the position of the apparatus (1) for finding faults relative to a lightning-protector cable or a power conductor and to move the apparatus (1) for finding faults along the overhead power transmission lines, wherein the apparatus (1) for finding faults contains the case (5), the battery (4) and the motor (6),
**characterized**
**in that** the case (5) is additionally outfitted with guides (9) configured to set the trajectory of the lightning-protector cable or power conductor inside the apparatus for finding faults in overhead power transmission lines to a position permitting locking of the apparatus (1) for finding faults on the lightning-protector cable or power conductor,
**in that** the drive system consists of two traveling rollers (10), which are configured to be rotated by the motor (6) for moving the apparatus (1) for finding faults, and of a clamping roller (11), which is configured to move relative to the lightning-protector cable or the power conductor, in a vertical plane with respect to a vertical position of the helicopter-type aircraft (8) and to clamp the lightning-protector cable or the power conductor to the traveling rollers (10), wherein the guides (9) are configured that, when the drive system has lowered the clamping roller (11), the lightning-protector cable or a power conductor is able to fall between them, is able with the aid of the guides (9) to bypass the clamping roller (11) and is able to fall between the clamping roller (11) and the travelling rollers (10) in order to clamp the lightning-protector cable or the power conductor to the traveling rollers (10) by lifting the clamping roller (11).

2. Apparatus for finding faults in overhead power transmission lines per Claim 1, wherein the helicopter-type aircraft (8) consists of an eight-rotor helicopter with protective enclosure, electronic stabilizer, control system, and electronic device for determining coordinates.

## Patentansprüche

1. Vorrichtung (1) zum Lokalisieren von Fehlern in Freileitungen, mit
einem Hubschraubertyp-Luftfahrzeug (8), einem Steuersystem und einer Vorrichtung (2, 3) zum Inspizieren von Freileitungen, die alle mit einer Batterie (4) verbunden sind, die an der Außenseite eines Gehäuses (5) der Vorrichtung (1) zum Lokalisieren von Fehlern angebracht ist, wobei die Vorrichtung (2, 3) zum Inspizieren von Freileitungen an der Außenseite des Gehäuses (5) angebracht ist, wobei das Steuersystem konfiguriert ist, um Daten, die durch Steuern des Betriebs der Vorrichtung (2, 3) zur Inspektion von Freileitungen gesammelt werden, zu beziehen, verarbeiten und analysieren,
wobei die Vorrichtung (1) zum Lokalisieren von Fehlern des Weiteren ein Antriebssystem aufweist, das in dem Gehäuse (5) angeordnet ist und mit einem Motor (6) verbunden ist, der über die Batterie (4) gespeist wird und der an der Batterie (4) angebracht ist, wobei das Antriebssystem konfiguriert ist, um die Position der Vorrichtung (1) zum Lokalisieren von Fehlern relativ zu einem Blitzschutzkabel oder einem Stromleiter zu arretieren und die Vorrichtung (1) zum Lokalisieren von Fehlern entlang der Freileitungen zu bewegen, wobei die Vorrichtung (1) zum Lokalisieren von Fehlern das Gehäuse (5), die Batterie (4) und den Motor (6) aufweist,
**dadurch gekennzeichnet,**
**dass** das Gehäuse (5) zusätzlich mit Führungen (9) ausgestattet ist, die so konfiguriert sind, um die Trajektorie des Blitzschutzkabels oder Stromleiters innerhalb der Vorrichtung zum Lokalisieren von Fehlern in Freileitungen auf eine Position festzulegen, die ein Arretieren der Vorrichtung (1) zum Lokalisieren von Fehlern an dem Blitzschutzkabel oder Stromleiter ermöglicht,
**dass** das Antriebssystem aus zwei Laufrollen (10), die konfiguriert sind, mittels dem Motor (6) zum Bewegen der Vorrichtung (1) zum Lokalisieren von Fehlern gedreht zu werden, und einer Klemmrolle (11) besteht, die konfiguriert ist, sich relativ zu dem Blitzschutzkabel oder dem Stromleiter in einer vertikalen Ebene in Bezug auf eine vertikale Position des Hubschraubertyp-Luftfahrzeugs (8) zu bewegen und das Blitzschutzkabel oder den Stromleiter an den Laufrollen (10) festzuklemmen, wobei die Führungen (9) so konfiguriert sind, dass, wenn das Antriebssystem die Klemmrolle (11) abgesenkt hat, das Blitzschutzkabel oder ein Stromleiter in der Lage ist, zwischen diese zu fallen, in der Lage ist, mit der Hilfe der Führungen (9) die Klemmrolle (11) zu umgehen, und in der Lage ist, zwischen die Klemmrolle (11) und die Laufrollen (10) zu fallen, um das Blitzschutzkabel oder den Stromleiter an den Laufrollen (10) durch Anheben der Klemmrolle (11) festzuklemmen .

2. Vorrichtung (1) zum Lokalisieren von Fehlern in Freileitungen nach Anspruch 1, wobei das Hubschraubertyp-Luftfahrzeugs (8) aus einem achtrotorigen Hubschrauber mit Schutzgehäuse, elektronischem Stabilisator, Steuersystem und elektronischer Vorrichtung zur Koordinatenbestimmung besteht.

## Revendications

1. Appareil (1) de diagnostic de lignes électriques aériennes, comprenant :
un aéronef de type hélicoptère (8), un système de commande et un appareil (2, 3) pour inspecter les lignes électriques aériennes, le tout raccordé à une batterie (4) qui est fixée à l'extérieur d'un carter (5) de l'appareil (1) de diagnostic, dans lequel l'appareil (2, 3) pour inspecter les lignes électriques aériennes est fixé à l'extérieur du carter (5), dans lequel le système de commande est configuré pour acquérir, traiter et analyser des données collectées en contrôlant le fonctionnement de l'appareil (2, 3) pour inspecter les lignes électriques aériennes,
dans lequel l'appareil (1) de diagnostic comprend en outre un système d'entraînement situé dans le carter (5) et raccordé à un moteur (6) qui est alimenté par la batterie (4) et qui est fixé à la batterie (4), le système d'entraînement est configuré pour bloquer la position de l'appareil (1) de diagnostic par rapport à un câble de parafoudre ou un conducteur d'alimentation et pour déplacer l'appareil (1) de diagnostic le long des lignes électriques aériennes, dans lequel l'appareil (1) de diagnostic comprend le carter (5), la batterie (4) et le moteur (6),
**caractérisé en ce que** le carter (5) est équipé, de plus, de guides (9) configurés pour régler la trajectoire du câble de parafoudre ou du conducteur d'alimentation à l'intérieur de l'appareil de diagnostic des lignes électriques aériennes dans une position permettant le blocage de l'appareil (1) de diagnostic sur le câble de parafoudre ou le conducteur d'alimentation,
**en ce que** le système d'entraînement se compose de deux rouleaux mobiles (10) qui sont configurés pour être entraînés en rotation par le moteur (6) pour déplacer l'appareil (1) de diagnostic, et d'un rouleau de serrage (11) qui est configuré pour se déplacer par rapport au câble de parafoudre ou au conducteur d'alimentation, dans un plan vertical par rapport à une position verticale de l'aéronef de type hélicoptère (8) et pour serrer le câble de parafoudre ou le conducteur d'alimentation sur les rouleaux mobiles (10), dans lequel les guides (9) sont configurés de sorte que, lorsque le système d'entraînement a baissé le rouleau de serrage (11), le câble de parafoudre ou un conducteur d'alimentation peut tomber entre eux, peut, à l'aide des guides (9), contourner le rouleau de serrage (11) et peut tomber entre le rouleau de serrage (11) et les rouleaux mobiles (10) afin de serrer le câble de parafoudre ou le conducteur d'alimentation sur les rouleaux mobiles (10) en levant le rouleau de serrage (11).

2. Appareil de diagnostic de lignes électriques aériennes selon la revendication 1, dans lequel l'aéronef de type hélicoptère (8) se compose d'un hélicoptère à huit rotors avec une enceinte de protection, un stabilisateur électronique, un système de commande et un dispositif électronique pour déterminer les coordonnées.
